# EUROPEAN PATENT SPECIFICATION

(11) **EP 0 477 443 B1**
(45) Date of publication and mention of the grant of the patent: **08.04.1998**
(21) Application number: 90310458.6
(22) Date of filing: 25.09.1990
(51) Int. Cl.: G03F 1/00, B41B 17/00, G03F 5/20

(54) **A method for forming plate characters in a half-tone gravure platemaking process**
Verfahren zum Formen von Buchstaben für die Herstellung von Halbton-Tiefdruckplatten
Méthode pour la formation de caractères d'impression pour la fabrication de plaques pour l'héliogravure en demi-teintes

(43) Date of publication of application: 01.04.1992
(73) Proprietor: THINK LABORATORY CO., LTD., Kashiwa-shi Chiba-ken 277 (JP)
(72) Inventor: Takakura, Kouichi, Kachiwa-shi, Chiba-ken, 277 (JP)
(74) Representative: Thomson, Paul Anthony

(56) References cited:
- WO-A-89/12256
- FR-A- 1 027 106
- FR-A- 1 290 052
- US-A- 2 662 455

## Description

### BACKGROUND OF THE INVENTION

### 1. Field of the Invention

The present invention relates to a method for forming plate characters in a half-tone gravure platemaking process which provides the same character quality as is found in type printing.

### 2. Prior Art

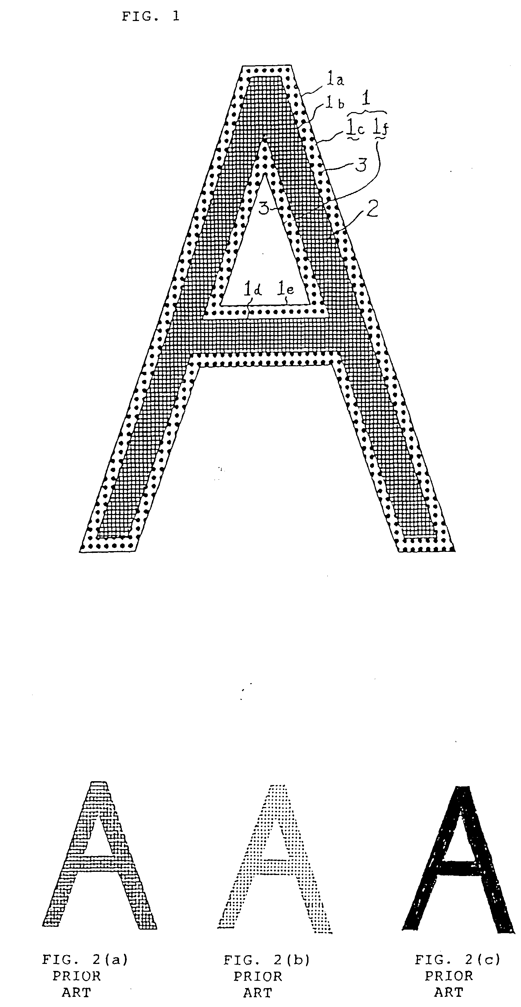

Figures 2(a) through 2(c) show a process of printing a letter "A" formed by a plate character obtained by prior art half-tone gravure platemaking method.

Fig. 2(a) shows a plate character "A" with a screen applied thereto, and the entire plate character consists of dot-form cells. The dot-form cells are formed by etching so that they have a shadow-portion dot percentage.

Fig. 2(b) shows a screen-applied plate character "A" of Fig. 2(a) upon which ink has been applied. When transfer-printing is performed onto paper, etc., the ink spreads and the blank-paper portions left by screen wires disappear, thus producing a letter "A" in which the entire character is black as shown in Fig. 2(c).

Thus, conventionally, plate characters are made up of dot form cells which have a shadow-portion dot percentage. Accordingly, the frames (or outlines) of the half-tone gravure characters (printed characters) are notched, and its quality is inferior to that of type-printed characters. Particularly, the quality of small characters is very low.

US-A-2 662 455 discloses a method for forming plate characters in a halftone gravure platemaking process in which each of said plate characters consists of a character frame portion and a character fill portion which is surrounded by said character frame portion, said character frame portion being formed by a continuous groove and said character fill portion being formed by dot-form cells which have a shadow-portion dot percentage. The process disclosed in such document uses a carbon tissue exposed to light through a positive transparency of the character, which carbon tissue is then applied against the plate or cylinder and developed. The plate or cylinder is then etched.

Exposure to light by means of a laser is conventional, as shown, for example, in WO-A-89 12 256.

### SUMMARY OF THE INVENTION

Accordingly, the object of the present invention is to provide a method for forming plate characters in a half-tone gravure platemaking process, wherein sharp character frames (such as those seen in type printing) in half-tone gravure characters are obtained, and a high-quality character printing is accomplished without causing any ink flow in the character frame portion.

According to the present invention there is provided a method for forming plate characters in a half-tone gravure platemaking process, wherein a laser beam is moved so as to be intermittently irradiated onto a light sensitive material, thus forming a plate character on said light-sensitive material by exposure so that said plate character consists of a character frame portion and a character fill portion which is surrounded by said character frame portion, said character frame portion being formed with continuous groove-form cells which have a prescribed length and width and dot-form projections formed in said groove-form cells for preventing ink flow and said character fill portion being formed with dot-form cells which have a shadow-portion dot percentage.

The half-tone gravure printing plates (in rolls or flat plates) of the present invention, as described above, have character frame portions formed by continuous groove-form cells, having a sufficiently small width. Also, dot-form projections are formed in the groove-form cells so that ink flow does not occur in the cells. In addition, the character fill portion is formed by dot-form cells which have a shadow-portion dot percentage. Accordingly, when the plate surface is wiped by a doctor, ink is applied in a favorable manner to the entire surface of the plate character, i.e., to both the character frame portion and the character fill portion, so that ink flow does not occur at the character frame portion when the character plate is wiped by a doctor. As a result, the ink in the character frame portion of the printed character is thick, and the character frame portion can be far sharper than that of type printing. In addition, the character fill portion is black, accomplishing high-quality character printing.

### BRIEF DESCRIPTION OF THE DRAWINGS

Figure 1 is an enlarged illustration of a plate character formed by the method of forming plate characters in a half-tone gravure platemaking process of the present invention; and
Figures 2(a) through 2(c) show a process of forming and printing a half-tone gravure character by means of a conventional method of forming plate characters in a half-tone gravure platemaking process.

### DETAILED DESCRIPTION OF THE INVENTION

A description of the present invention will be made below with reference to a direct platemaking process in which a laser beam is moved so that the laser beam is intermittently irradiated (or flashed) onto the surface of a plate roll, which is coated with a light-sensitive film, thus causing a formation of character information (by exposure) as an aggregation of beam dots.

In other words, a single laser beam is split by a beam splitter into approximately 20 beams, which are of equal intensity and arranged in chain form, and each beam is irradiated onto a plate roll (which is coated with a light sensitive film to constitute the light-sensitive material) by a multi-type light modulator (which is driven in accordance with character information) and through auto-focus lenses, so that laser exposure is performed as the laser scans.

When a letter "A", for example, is to be be written onto the plate roll via laser exposure, multi-electrodes of a multi-type light modulator are driven so that the character frame portion is continuously exposed (by the laser beams) and the character fill portion (i.e., the area inside the character frame portion) is exposed so that the character fill portion is filled with dot-form cells having a shadow-portion dot percentage.

The multi-type light modulator is driven so that it receives character information from a memory which stores such character information, converting such information into necessary signals and then distributing the signals to the multi-electrodes. The character information stored in the memory is laid out together with image information in a layout scanner.

In the layout scanner an accessory program is used so that for a character displayed in the graphic display, the accessory program can define picture element information separately between the character frame portion and the character fill portion. Thus, as shown in Fig. 1, the character frame portion 1 is defined by two areas 1c (which corresponds to a "groove-form cell" described later) and 1f (which also corresponds to a "groove-form cell" described later). The area 1c is an area surrounded by two outside outlines 1a and 1b, and the area 1f is an area surrounded by two inside outlines 1d and 1e. The width of each of the areas 1c and 1f is defined as, for instance, 30 µm (microns), and the areas 1c and 1f having the width of 30 µm (microns) and defined by the outlines are provided with black dots (which corresponds to "dot-form projections 3") of predetermined size and shape. Furthermore, the character fill portion 2 is defined as having a shadow-portion dot percentage (e.g. a shade gradient of 75%) as shown in Fig. 1. These values are stored in the memory.

In the above case, it is preferable to form both ends of the character frame portion 1 as sharp triangle end in shape. With this arrangement, the sharp ends of the character frame portion come in point contact with sharp ends of the character frame portions of adjacent characters.

When a plate roll, which has been laser-exposed as described above, is developed/etched, a plate character is formed. In the character frame portion 1, the area 1c, which is defined by continuous two outside outlines parted for 30 µm (microns), becomes a continuous groove-form cell surrounding outside of the plate character when the area 1c is etched. The area 1f, defined by the two inside outlines, becomes a continuous groove-form cell surrounding the inside border of the character when the area 1f is etched. The projections 3 scattered in areas 1c and 1f remain as is without being etched so that the projections 3 prevents the ink flow in the character frame portion when the plate surface is wiped by a doctor.

On the other hand, in the character fill portion 2 (i.e., the area inside the character frame portion), a half-tone etching is performed so that the character fill portion 2 is formed by dot-form cell which has a shadow-portion dot percentage.

When ink is applied to the plate character and transfer printing is performed onto paper, etc., the ink is thick in the character frame portion while it spreads out (as in convention methods) in the character fill portion (i.e., the area inside the character frame portion) so that the blank paper areas left by the screen wires disappear. Thus, a printed letter "A" is sharp and black overall and shows no notching.

The method of forming a plate character in a half-tone gravure platemaking process provided by the present invention may also be used in which (a) a laser beam is moved so that a light-sensitive film (silver salt film) wrapped around a drum is subject to a flashing irradiation of laser beams, thus forming, by exposure, character information as aggregates of beam dots, (b) the light-sensitive film is then developed and wrapped around a plate roll coated with another light-sensitive film so that another exposure is performed, and (c) developing/etching is then performed so that plate characters which are made up of network points are formed.

As describe above, according to the method for forming plate characters in a half-tone gravure platemaking process of the present invention, the ink in the character frame portion is thick and there is no danger that ink flow would occur in the character frame portion. Accordingly, the character frame portion is far sharper than in the case of type printing, achieving high-quality character printing.

## Claims

1. A method for forming plate characters in a half-tone gravure platemaking process, wherein a laser beam is moved so as to be intermittently irradiated onto a light sensitive material, thus forming a plate character on said light-sensitive material by exposure so that said plate character consists of a character frame portion and a character fill portion which is surrounded by said character frame portion, said character frame portion being formed with continuous groove-form cells which have a prescribed length and width and dot-form projections formed in said groove-form cells for preventing ink flow and said character fill portion being formed with dot-form cells which have a shadow-portion dot percentage.

## Patentansprüche

1. Verfahren zum Formen von Buchstaben für die Herstellung von Halbton-Tiefdruckplatten, bel dem ein Laserstrahl derart bewegt wird, daß er diskontinuierlich ein lichtempfindliches Material beaufschlagt, wodurch ein Buchstabe auf dem lichtempfindlichen Material durch Belichtung geformt wird, so daß der Buchstabe aus einem Buchstaben-Rahmenteil und einem Buchstaben-Füllteil, welcher von dem Buchstaben-Rahmenteil umgeben ist, besteht, wobei der Buchstaben-Rahmenteil mit durchgehenden rillenförmigen Zellen gebildet ist, welche eine vorgeschriebene Länge und Breite haben, und in denen punktförmige Erhöhungen angeordnet sind, um Tintenfluß zu verhindern, und wobei der Buchstaben-Füllteil mit punktförmigen Zellen geformt ist, welche einen abschattungsgemäßen Punktanteil haben.

## Revendications

1. Un procédé d'obtention de caractères d'impression dans un procédé de fabrication de plaques pour l'héliogravure à demi-teintes, dans lequel un faisceau laser est déplacé afin d'irradier de façon intermittente un matériau photosensible, formant ainsi par insolation un caractère d'impression sur le matériau photosensible, de sorte que ledit caractère d'impression consiste en une partie contour dn caractère et une partie de remplissage du caractère, qui est entourée par la partie contour du caractère, ladite partie contour du caractère étant formée avec des cellules en forme de rainures continues ayant une longueur et une largeur imposées et des éléments en saillie en forme de points formés dans lesdites cellules en forme de rainure afin d'empêcher l'écoulement d'encre, et ladite partie de remplissage du caractère étant formée avec des cellules en forme de points, présentant un pourcentage de points correspondant à un dégradé.
